Europäisches Patentamt

European Patent Office

Office européen des brevets

(11) Publication number: **0 219 285 B1**

# EUROPEAN PATENT SPECIFICATION

(45) Date of publication of patent specification: **11.09.91**  (51) Int. Cl.⁵: **H01G 1/14**, H01C 1/14, H01L 21/00

(21) Application number: **86307665.9**

(22) Date of filing: **03.10.86**

(54) Assembly of a substrate, an electrical device and a terminal.

(30) Priority: **07.10.85 US 785329**

(43) Date of publication of application:
**22.04.87 Bulletin 87/17**

(45) Publication of the grant of the patent:
**11.09.91 Bulletin 91/37**

(84) Designated Contracting States:
**CH DE FR GB IT LI NL**

(56) References cited:
**FR-A- 2 371 049       GB-A- 504 452
GB-A- 968 989        GB-A- 1 123 324
GB-A- 1 584 150      US-A- 3 411 193**

(73) Proprietor: **ILLINOIS TOOL WORKS INC.
8501 West Higgins Road
Chicago Illinois 60631(US)**

(72) Inventor: **Rayburn, Charles C.
124 Sunset Ridge
Forest Virginia 24551(US)**

(74) Representative: **Gordon, Michael Vincent et al
GILL JENNINGS & EVERY 53-64 Chancery
Lane
London WC2A 1HN(GB)**

## Description

The present invention is directed to an assembly of a substrate, an electrical device and a terminal providing electrical access to the device through a hole in the substrate.

It is known from GB-A-1584150 for a terminal to have a strain-relieving structure between its attachment end and its free end, the strain-relieving structure being formed by a segment of an electrically conductive rod which is broadened in a first plane and narrowed in a second plane.

It is also known from GB-A-968989, which is acknowledged in more detail in the introductory portion of the following independent claim, that in an assembly of a terminal, an electrical device and a substrate with a hole, the terminal can be a rod of electrically conductive material having an attachment end and a free end separated by a strain-relieving structure which has a broadened portion in abutment with an edge of the hole at one side of the substrate, the free end of the rod passing through the hole to the other side of the substrate so that the device and the substrate are spaced from one another by a gap.

In accordance with the present invention an assembly comprises a substrate, an electrical device and a terminal providing electrical access to the device through a hole in the substrate;

the terminal being a rod of electrically conductive material having an attachment end, a free end and a strain-relieving structure which is located intermediate said attachment end and said free end, the strain-relieving structure including a segment of the rod which has been broadened in a first plane to a dimension greater than those of the rod and the hole and narrowed in a second plane perpendicular to the first plane to a dimension less than that of the rod, and the segment establishing an attachment portion which is affixed to an electrical contact area of the device as well as establishing a broadened portion which is in abutment with an edge of the hole at one side of the substrate, the free end of the rod passing through the hole to the other side of the substrate so that the device and the substrate are spaced from one another by a gap;

characterised in that the entire length of the attachment portion between the broadened portion and the attachment end of the rod is embedded in the contact area at an adjacent face of the device up to a depth which places the broadened portion in abutting relationship to the surface of the contact area, the embedded length of the rod is spaced from a boundary of the face by a shoulder comprising a portion of the contact area which is in abutment with only a part of the broadened portion, and the remaining part of the broadened portion traverses the boundary to be located in free space and to define the dimension of the gap spacing the device from the substrate.

Advantages of the assembly of the present invention are:

its ability to provide a termination joint between the terminal and the electrical device which is strong and better able to withstand the rigors of automated insertion equipment commonly encountered in high volume production environments;

its ability to provide a termination joint which is significantly more resistive to breakage under a prying force than is provided by prior art structures;

its ability to attach the terminal in an embedded relationship to establish the shoulder which enhances the terminal joint's resistance to breakage by a radial force applied along the longitudinal axis of the terminal;

its ability for the terminal to have a uniform attachment length to facilitate use of uniform weld energy levels to produce a constant weld strength which is reliably and repeatably attainable in a production volume environment;

its ability to establish uniform lead spacing in a production volume environment;

its ability to provide a uniform distribution of energy during attachment of the terminal, thereby facilitating a repeatable reliable termination joint in a production volume environment; and

its ability for the termination joint to be displaced from the boundary between the electrical device and the free space, thereby avoiding an electrical current concentration at the boundary which might cause burning of the terminal.

An assembly, in accordance with the present invention, will now be described in more detail, by way of example only, with reference to the accompanying drawings, in which:-

Fig. 1 is a side schematic view illustrating the relationship of the terminal to the electrical device both in an installed and in a non-installed relationship; and

Fig. 2 is an end view of Fig. 1, also showing the substrate.

An assembly includes a terminal 10 which comprises a rod 11 of electrically conductive material having an attachment length 14, a free end 16, and strain-relieving structure 18 intermediate the attachment length 14 and the free end 16.

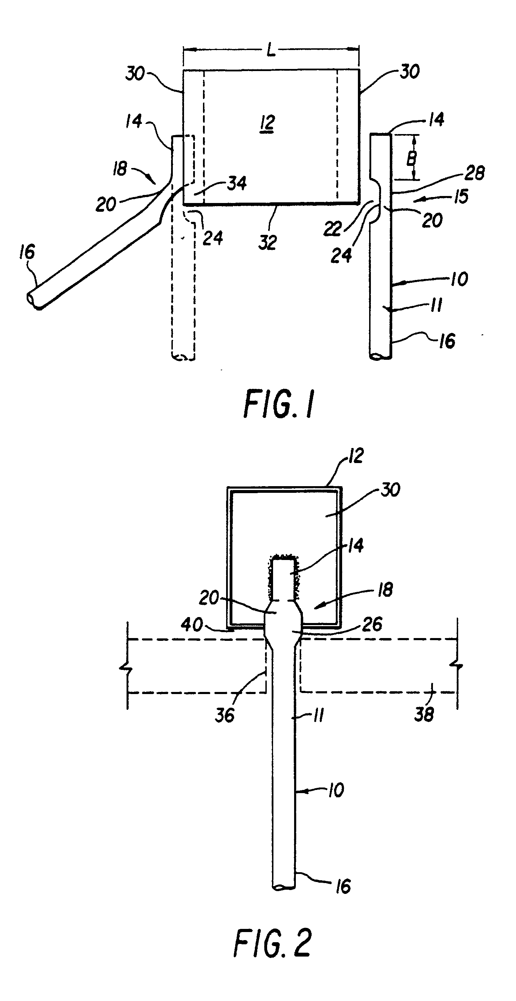

The strain-relieving structure 18 is formed as a segment 20 of the rod 11, which segment 20 is broadened to a dimension greater than the rod 11 in a first plane (the broadening is more clearly seen in Fig. 2) and narrowed to a dimension less than the rod 11 in a second plane (most clearly visible in Fig. 1).

The segment 20 is established by displacement of material of the rod 11 from one side, as at 22, thereby forming a depression 24 in the rod 11. The formation of the depression 24 displaces material to form the broadened portion 26 of the segment 20. A consequence of this formation of the broadened portion 26 by the depression 24 is that the segment 20 is coterminous with the rod 11 at a second side 28 of the rod 11. The second side 28 is substantially opposite the first side 22 and, as is illustrated in Fig. 1, terminal 10 is mounted to an electrical device 12 by the joining of the attachment length 14 at the first side 22 of the rod 11 to an electrical contact area 30 of the electrical device 12.

The electrical contact area 30 of the electrical device 12 is comprised of electrically conductive material providing electrical contact with appropriate internal portions (not shown) of the electrical device 12 by attachment to the outer surface of the electrical contact area 30. Thus, as seen on the left side of the electrical device 12 in Fig. 1, in its installed position the terminal 10 is embedded in the electrical contact area 30 by its attachment length 14 to a depth which places the depression 24 in abutting relationship to the surface of the electrical contact area 30.

As may be seen by the dual position indication of the terminal 10 at the left side of the electrical device 12 in Fig. 1, the moment arm between the depression 24 and the point of joining between the terminal 10 and the electrical contact area 30 (i.e. the attachment length 14) is extremely short so that minimal moment-force or prying force is applied to the joint between the attachment length 14 and the electrical contact area 30 when the free end 16 is moved from the installed position (shown in phantom in Fig. 1 at the left side) to the position indicated in solid lines at the left side of Fig. 1 in applying a prying force to the terminal 10.

The terminal 10 bends at the strain-relieving structure 18 to relieve the forces of such a prying motion of the terminal 10 to protect the joint. The joint is further protected by the minimization of the moment arm between the strain-relieving structure 18 and the joint, ensuring that the amount of force required to bend the strain-relieving structure 18 will not be multiplied by any significant moment arm to weaken the joint. Thus, the joint between the terminal 10 and the electrical device 12 by the attachment length 14 and the electrical contact area 30 is significantly better able to withstand a prying-motion-induced force applied to the free end 16 of the terminal 10.

By location of the depression 24 upon the rod 11 during manufacture of the terminal 10 to provide a uniform dimension B of the attachment length 14, one may control the surface area of the terminal 10 which interacts to form the joint with the electrical contact area 30 by ensuring that the attachment length 14 is constant. Thus, when a welding operation is performed to attach the terminal 10 to the electrical contact area 30, a constant dimension B of attachment length 14 is in contact with the electrical contact are a 30, thereby rendering the attachment process more repeatable and constant in nature. As a consequence, a more repeatable, constant power requirement is necessary to effect the welding; further, the weld joining the attachment length 14 to the electrical contact area 30 will be more repeatable and constant as well. All of the above factors of repeatability and consistence are distinct advantages leading to greater reliability of products in a production volume environment.

When the terminal 10 is welded to the electrical contact area 30, as in the preferred embodiment of this arrangement illustrated at the left side of Fig. 1, the depression 24 is situated to traverse the boundary 32 between the electrical contact area 30 and free space. Thus, it may be seen that the attachment length 14 is displaced from the boundary 32 and there is thereby created a shoulder 34 of material comprising a portion of the electrical contact area 30. In such manner, the joint between the attachment length 14 and the electrical contact area 30 is strengthened against radial forces applied along the longitudinal axis of the terminal 10 by a buttressing effect provided by the shoulder 34.

The formation of the depression 24 on the first side 22 of the terminal 10, which first side 22 is in abutting relationship with the electrical contact area 30 when the terminal 10 is installed in its joined relationship with the electrical device 12, is the source of an additional benefit of the structure of the present invention. By providing that the depression 24 bottoms out on the electrical contact area 30 during the welding thereto of the terminal 10 by its attachment length 14, there is provided a shunting of electrical energy during the welding of the terminal 10 to the electrical contact area 30.

When the welding process used for attachment of the terminal 10 is the plasma welding process described in U.S. Patent 4,535,381 (RAYBURN), such extinguishing of the plasma formed during that welding process serves to precisely position the terminal 10 on the surface of the electrical contact area 30. Since the length L of the electrical device is controllable in the production process, it is therefore a beneficial result that the separation of the terminals 10 in their installed position is precisely established because the depth of penetration of the attachment length 14 into the electrical contact area 30 is well conrolled by the plasma extinguishing effect of the depression 24 when it contacts the electrical contact area 30 during the attachment process.

Yet another advantage of the limitation of the depth of penetration of the terminal 10 into the electrical contact area 30 because of such extinguishment of the plasma during attachment is that inadvertent shorting of components within the electrical device 12 is precluded.

In automated insertion equipment commonly found in circuit manufacturing facilities today, the axial force (i.e. the force applied along the longitudinal axis of the terminal 10) experienced by a joint such as the joint between attachment length 14 and electrical contact area 30 can vary greatly during processing operations. Such variations depend upon numerous factors, including the sharpness of cutters trimming the terminals 10, thepositioning of those cutters or other tools, the crimping angle at which the free ends 16 may be crimped to prevent dislodgement from holes through which the terminals 10 are fair-leaded, the angle of cut of the cutters, and the like.

When the body of the electrical device 12 in its installed position abuts a circuit board, there is little elasticity in the system comprising the electrical device 12 and its associated terminals 10. In such configurations an axial force of approximately 1/2 pound/($\frac{1}{4}$ kg) can pull a terminal 10 a distance of a few thousandths of an inch/(cm). Displacements of that magnitude can result in the fracture of some of the joints between the terminals 10 and the electrical contact areas 30.

The provision of the strain-relieving structure 18 with its broadened portion 26 provides a solution to this problem, as illustrated in Fig. 2. By selection of a hole 36 in a substrate 38 with a diameter smaller than the breadth of the broadened portion 26, any axial force applied to the free end 16 will be borne by the intereference fit between the broadened portion 26 and the edges of the hole 36. Thus, any strain upon the joint between the attachment length 14 and the electrical contact area 30 caused by axial forces is relieved.

A further advantage of the provision of a broadened area 26 on the terminals 10 is that a gap 40 between the body of the electrical device 12 and substrate 38 is created, which gap facilitates cleaning of flux or other contaminants from beneath and around the electrical device 12 after its installation. The creation of electrical leakage paths about the electrical device 12 is thereby precluded.

Still a further advantage of the broadened portion 26 of the terminal 10 is that there is thereby created an increased thermal path and an increased area for dissipation of thermal energy from the terminal 10 during soldering operations by which the terminals 10 are electrically connected to circuitry carried upon the substrate 38. In such manner, the joint between the attachment length 14 and the electrical contact area 30 is subjected to less heat than would be present in the absence of the broadened portions 26.

## Claims

1. An assembly comprising a substrate (38), an electrical device (12) and a terminal (10) providing electrical access to the device (12) through a hole (36) in the substrate (38);

   the terminal (10) being a rod (11) of electrically conductive material having an attachment end, a free end (16) and a strain-relieving structure (18) which is located intermediate said attachment end and said free end, the strain-relieving structure (18) including a segment (20) of the rod (11) which has been broadened in a first plane to a dimension greater than those of the rod (11) and the hole (36) and narrowed in a second plane perpendicular to the first plane to a dimension less than that of the rod (11), and the segment (20) establishing an attachment portion (14) which is affixed to an electrical contact area (30) of the device (12) as well as establishing a broadened portion (26) which is in abutment with an edge of the hole (36) at one side of the substrate (38) , the free end (16) of the rod (11) passing through the hole (36) to the other side of the substrate (38) so that the device (12) and the substrate (38) are spaced from one another by a gap (40);

   characterised in that the entire length of the attachment portion (14) between the broadened portion (26) and the attachment end of the rod (11) is embedded in the contact area (30) at an adjacent face (30) of the device (12) up to a depth which places the broadened portion (26) in abutting relationship to the surface of the contact area (30), the embedded length of the rod (11) is spaced from a boundary (32) of the face (30) by a shoulder (34) comprising a portion of the contact area (30) which is in abutment with only a part of the broadened portion (26), and the remaining part of the broadened portion (26) traverses the boundary (32) to be located in free space and to define the dimension of the gap (40) spacing the device (12) from the substrate (38).

## Revendications

1. Assemblage comportant un substrat (38), un dispositif électrique (12) et une borne (10) établissant un accès électrique au dispositif (12) par un trou (36) situé dans le substrat (38) ;

   la borne (10) étant une tige (11) de matière électriquement conductrice ayant une extrémité de fixation, une extrémité libre (16) et une structure (18) de soulagement de contraintes qui est située entre ladite extrémité de fixation et ladite extrémité libre, la structure (18) de soulagement de contraintes comprenant un segment (20) de la tige (11) qui a été élargi dans un premier plan jusqu'à une dimension supérieure à celles de la tige (11) et du trou (36) et rétréci dans un second plan perpendiculaire au premier plan, jusqu'à une dimension inférieure à celle de la tige (11), et le segment (20) établissant une partie (14) de fixation qui est fixée à une zone (30) de contact électrique du dispositif (12), et établissant aussi une partie élargie (26) qui est en butée avec un bord du trou (36) sur un premier côté du substrat (38), l'extrémité libre (16) de la tige (11) passant dans le trou (36) jusqu'à l'autre côté du substrat (38) afin que le dispositif (12) et le substrat (38) soient espacés l'un de l'autre par un intervalle (40);

caractérisé en ce que la longueur entière de la partie (14) de fixation entre la partie élargie (26) et l'extrémité de fixation de la tige (11) est encastrée dans la zone de contact (30) à une face adjacente (30) du dispositif (12) jusqu'à une profondeur qui place la partie élargie (26) en butée contre la surface de la zone de contact (30), la longueur encastrée de la tige (11) est espacée d'une limite (32) de la face (30) par un épaulement (34) comprenant une partie de la zone (30) de contact qui est en butée avec seulement une portion de la partie élargie (26), et la portion restante de la partie élargie (26) franchit la limite (32) pour être placée dans un espace libre et pour définir la dimension de l'intervalle (40) espaçant le dispositif (12) du substrat (38).

## Patentansprüche

1. Anordnung mit einem Substrat (38), einem elektrischen Bauteil (12) und einem Anschluß (10) zur Schaffung eines elektrischen Zuganges zu dem Bauteil (12) durch ein Loch (36) in dem Substrat (38), wobei der Anschluß (10) ein Stab (11) aus elektrisch leitfähigem Material ist, der ein Befestigungsende, ein freies Ende (16) und eine spannungsvermindernde Struktur (18) aufweist, die zwischen dem Befestigungsende und dem freien Ende angeordnet ist, die spannungsvermindernde Struktur (18) ein Segment (20) des Stabes (11) beinhaltet, das in einer ersten Ebene auf eine größere Dimension als die des Stabes (11) und des Loches (36) erweitert ist, und das in einer senkrecht zur ersten Ebene zweiten Ebene auf eine geringere Dimension als die des Stabes (11) verengt ist, und das Segment (20) einen Befestigungsabschnitt (14), der an einem elektrischen Kontaktbereich (30) des Bauteils (12) befestigt ist, festlegt sowie einen erweiterten Abschnitt (26), der an einer Kante des Loches (36) an einer Seite des Substrates (38) anliegt, das freie Ende (16) des Stabes (11) sich durch das Loch (36) zu der anderen Seite des Substrates (38) erstreckt, so daß das Bauteil (12) und das Substrat (38) durch eine Lücke (40) voneinander beabstandet sind;

dadurch gekennzeichnet, daß die gesamte Länge des Befestigungsabschnittes (14) zwischen dem erweiterten Abschnitt (26) und dem Befestigungsende des Stabes (11) in dem Kontaktbereich (30) an einer benachbarten Fläche (30) des Bauteils (12) bis zu einer Tiefe eingebettet ist, die den erweiterten Abschnitt (26) in anliegender Beziehung zu der Fläche des Kontaktbereiches (30) anordnet, die eingebettete Länge des Stabes (11) von einem Rand (32) der Fläche (30) durch eine Schulter (34) beabstandet ist, wobei die Schulter ein Abschnitt des Kontaktbereiches (30) darstellt und der Kontaktbereich nur mit einem Teil des erweiterten Abschnitts (26) in anliegender Berührung ist, während der restliche Teil des erweiterten Abschnitts (26) quer zu dem Rand (32) verläuft, im freien Raum angeordnet ist und die Dimension der Lücke (40), die das Bauteil (12) von dem Substrat (38) beabstandet, definiert.

FIG. 1

FIG. 2